# EUROPEAN PATENT SPECIFICATION

(11) **EP 0 604 775 B1**
(45) Date of publication and mention of the grant of the patent: **31.01.1996**
(21) Application number: 93119291.8
(22) Date of filing: 30.11.1993
(51) Int. Cl.: H01L 21/00

(54) **Apparatus for forming a film**
Apparat um einen Film zu bauen
Appareil pour former un film

(30) Priority: 30.11.1992 JP 320503/92
(43) Date of publication of application: 06.07.1994
(73) Proprietor: CANON SALES CO., INC., Minato-ku, Tokyo 108 (JP); ALCAN-TECH CO., INC., Tokyo 108 (JP); SEMICONDUCTOR PROCESS LABORATORY CO., LTD., Minato-ku, Tokyo 108 (JP)
(72) Inventor: Maeda, Kazuo, c/o Semiconduct. Process Lab. Co.Ltd, Tokyo (JP); Ohira, Kouichi, c/o Semicond. Process Lab. Co.Ltd, Tokyo (JP); Chino, Hiroshi, c/o Semicond. Process Lab. Co.Ltd, Tokyo (JP)
(74) Representative: Marx, Lothar, Dr.

(56) References cited:
- EP-A- 0 319 121
- EP-A- 0 399 616
- EP-A- 0 467 624
- EP-A- 0 532 758

## Description

### BACKGROUND OF THE INVENTION

### 1. Field of the Invention

The present invention relates to an apparatus for forming a film, particularly to an automated and continuous apparatus for forming a film through CVD (Chemical Vapor Deposition).

### 2. Field of the Related Art

The CVD apparatus for mass production includes the following types.
(1) Batch process CVD apparatus
(2) Continuous CVD apparatus
   (a) Conveyer type
   (b) Walking beam type
(3) Multi-chamber CVD apparatus

Though the above batch process CVD apparatus for forming a film on many wafers at the same time has a high mass productivity, it cannot correspond to the increase of wafer diameter or it is not suitable for accurate production control. Moreover, the throughput is not always high because the treatment speed is low.

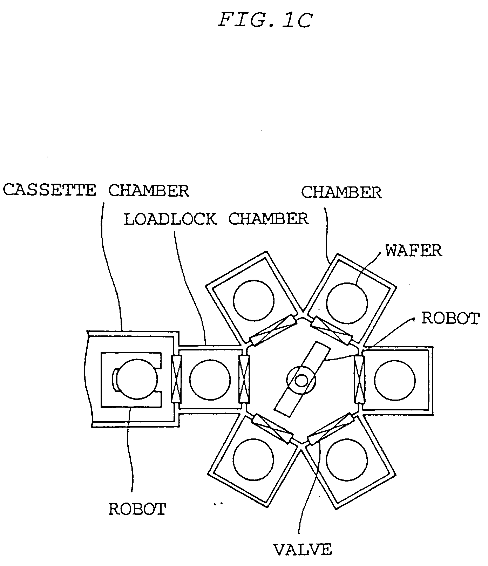

The multi-chamber CVD apparatus mainly used for forming a film under a low pressure shown in Fig. 1C performs various types of treatments and has a high flexibility because each chamber is independently formed. However, the throughput is considerably low.

Therefore, in order to correspond to the increase of wafer diameter and realize a high throughput, the continuous CVD apparatus for forming a film in order on a plurality of wafers is advantageous.

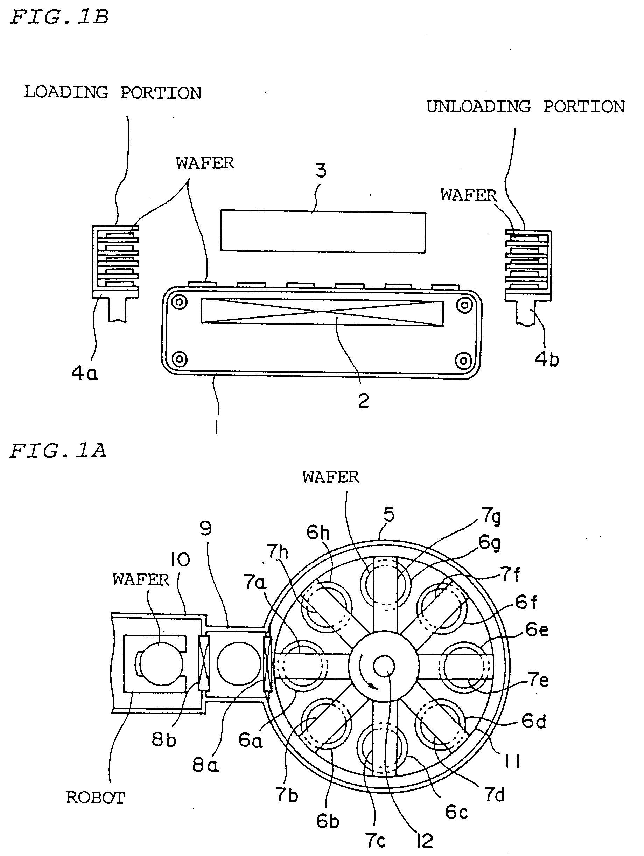

Fig. 1A shows a conveyer-type continuous CVD apparatus which is mainly used to form a film under the normal pressure. Symbol 1 is a conveyer belt and 2 is a heater secured under the conveyer belt 1 separately from the belt 1. Symbol 3 is a gas distributor provided above the conveyer belt 1, 4a is a cassette station of a wafer loading portion, and 4b is a cassette station of a wafer unloading portion. Wafers are mounted on the conveyer belt 1 and sent in order, and indirectly radiant-heated by heater 2 provided under the conveyer belt 1.

Fig. 1B shows a walking-beam-type continuous CVD apparatus which is mainly used to form a film through plasma CVD under a low pressure. Symbol 5 is a chamber and symbols 6a to 6h are susceptors having a heater respectively which are secured to a base 11. Symbols 7a to 7h are eight walking beams rotatable around a rotary shaft 12 by holding wafers and 8a and 8b are gate valves. Symbol 9 is a load-lock chamber connected to the chamber 5 through the gate valve 8a and 10 is a cassette chamber connected to the load-lock chamber 9 through the gate valve 8b.

A film is formed by using the apparatus as shown below. First, a wafer is moved from the load-lock chamber 9 onto the susceptor 6a in the chamber 5 and thereafter it is heated up to a predetermined temperature by a heater under the susceptor 6a.

Then, a film is formed on the wafer on the susceptor 6a and thereafter the wafer is moved to the susceptor 6b by the walking beam 7a to form the next film. At the same time, the next wafer is moved from the load-lock chamber 9 onto the susceptor 6a in the chamber 5 and heated up to a predetermined temperature by a heater under the susceptor 6a. According to the above procedure, a film is formed on the wafer on the susceptors 6a and 6b.

Thus, wafers are introduced into the chamber 5 one by one to continuously form films on wafers while moving them onto the susceptors 6a to 6h in order. Therefore, by passing a wafer through the susceptors 6a to 6h once, it is possible to form different types of multilayer films or single-layer films with a predetermined thickness on the wafer.

(1) However, the conveyer-type CVD apparatus has problems that it is difficult to accurately measure the wafer temperature because a wafer moves on the secured heater 2 and it is impossible to accurately control the wafer temperature because the heater 2 is to some extent separate from the conveyer belt 1.

(2) Also for the walking-beam-type CVD apparatus, it cannot be avoided that the wafer temperature lowers because a wafer separates from the heater under the susceptors 6a to 6h. Therefore, the CVD apparatus has a problem that strain is left in a formed film because a temperature cycle is given during film forming. Moreover, the apparatus has another problem that a lot of time is required to stabilize the wafer temperature and temperature adjustment is complex because it is necessary to reheat a wafer to keep the wafer temperature at a predetermined value when moving the wafer from the susceptor 6a to the next susceptor 6b.

To solve these problems, it is considered to secure a wafer holder to a heater and move a gas distributor. However, there is a problem that wafers cannot be continuously treated because they do not move.

Moreover, there is a problem that operations cannot be efficiently performed because both a wafer holder and heater must be replaced or removed for maintenance or checkout even when it is enough to replace or remove one of them.

Document EP-A-319 121 discloses an apparatus for producing semiconductors with at least one reaction chamber, which is provided within a vacuum chamber, wherein at least one substrate is held by the top plate of this reaction chamber, and the reaction chamber is filled with a reactant gas mixture while the substrate is heated from above by means of heating means disposed above the reaction chamber. Especially the known apparatus comprises a rotary shaft, heating means arranged in a circle around said rotary shaft, a plurality of gas dischargers discharging a reaction gas and facing said heating element, and a wafer holder, which is rotated about the rotary shaft along a single plane between said heating means and said gas dischargers. Further, the wafer holder has a plurality of detachable susceptors, holding a plurality of substrates.

Because the known apparatus comprises only one heating means which is situated above the plurality of substrates, it is impossible to independently control the temperature of each substrate. Further, since the wafer holder according to EP-A-319 121 only secures the substrate by an edge thereof, the substrate has only its inherent heat capacity. Since, however, the substrate has a smaller heat capacity than the wafer mounting table, the temperature of the substrate can easily fluctuate during its contact with the reaction gas.

### Summary of the Invention

An object of the present invention is to provide an apparatus for forming a film, as defined in the preabmle of claim 1 which makes it possible to continuously form the film while keeping the temperature of the wafer at a predetermined and accurately controlled value, so that maintainance and check-out can be easily performed.

This object is solved by the features of claim 1.

Suitable embodiments are defined by the features of the subclaims.

### BRIEF DESCRIPTION OF THE DRAWING

Fig. 1A is a side view of a conveyer-type continuous CVD apparatus for continuously forming a film one after another according to the related art, Fig.1B is a top view of a walking-beam-type continuous CVD apparatus according to the related art, and Fig.1C is a side view of a multi-chamber CVD apparatus according to the related art;
Figs. 2A and Figs. 2B are a top view and a side view respectively showing the detailed constitutions of a susceptor and a holder having both an exhaust pipe and a thermocouple in the CVD apparatus of an embodiment of the present invention;
Figs. 3A and Figs. 3B are a top view and a side view respectively showing the state in which a holder is detached from a susceptor by the movement of the holder and Figs. 3C and Figs. 3D are a top view and a side view respectively showing the state in which the holder is set to the susceptor by the movement of the holder;
Figs. 4A to Figs. 4C are a top view and a side views respectively showing the detailed constitution of a frame for setting a wafer mounting table of the susceptor of an enbodiment of the present invention;
Figs. 5A and Figs. 5B are a top view and a side view respectively showing the detailed constitution of a frame of a heat insulating material for holding a wafer mounting table of the susceptor of an enbodiment of the present invention;
Figs. 6A to Figs. 6C are a top view and side views respectively showing the detailed constitution of a wafer mounting table of the susceptor of an embodiment of the present invention;
Fig. 7 is a side view showing the entire constitution of the CVD apparatus of an embodiment of the present invention;
Fig. 8 is a top view showing the detailed constitution of a wafer holder of the CVD apparatus of an embodiment of the present invention;
Fig. 9 is a top view showing the detailed constitution of a gas distributor of the CVD apparatus of an embodiment of the present invention;
Fig. 10 is a side view showing the states in which a heater of the CVD apparatus of an embodiment of the present invention rotates and a susceptor is attached or detached; and
Figs. 11A to Figs. 11C are typical views showing a semiconductor device manufacturing method using the CVD apparatus of an embodiment of the present invention.

### DESCRIPTION OF THE PREFERRED EMBODIMENT

### (1) Description of CVD apparatus of the first embodiment of the present invention

### (A) Description of entire constitution of CVD apparatus of the first embodiment of the present invention

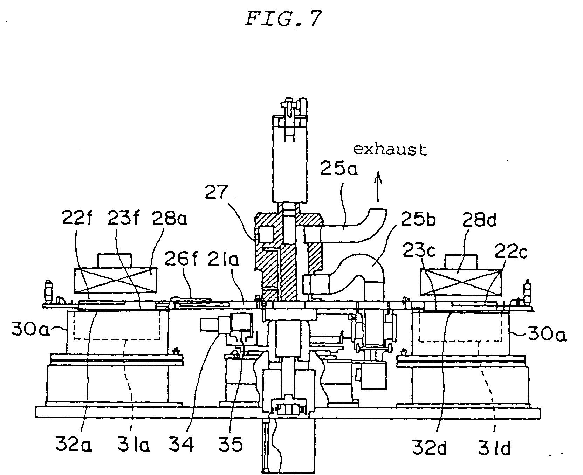

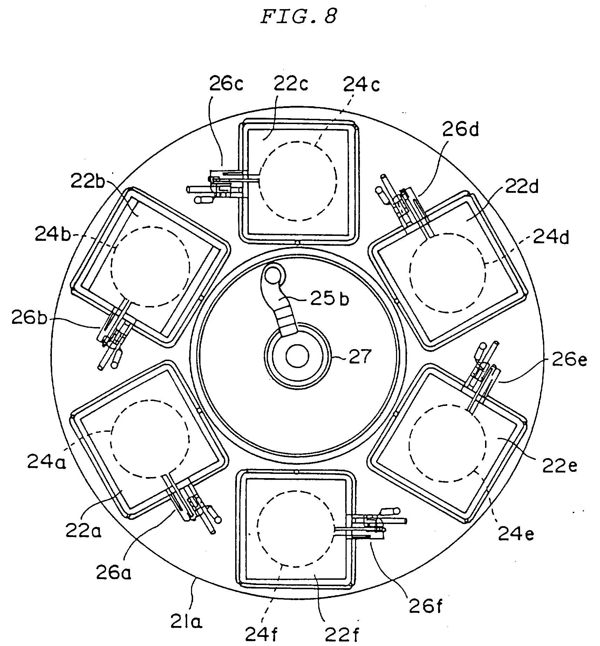

Referring to Figs. 7 to Figs. 10 the entire constitution of the CVD apparatus of the first embodiment of the present invention is described below.

In Figs. 7, Figs. 8, and Figs. 10, symbol 21 is a discoid wafer holder on which six detachable susceptors 22a to 22f are set. Wafer mounting surfaces 23a to 23f of the susceptors 22a to 22f are turned downward, thereby wafers 24a to 24f mounted on the wafer mounting surfaces 23a to 23f face gas discharge surfaces 32a to 32e of a gas distributor 30. A pipe 25b is connected to the wafer holder 21, whereby a gas is exhausted or introduced through the pipe 25b and a exhaust port/gas introduction port 25a. Moreover, The susceptors 22a to 22f are provided respectively with such a not-illustrated oscillation unit that each of the susceptors performs a rotary motion around each axis vertical to the wafer mounting surfaces 23a to 23f or a linear motion in the radius direction.

Symbols 26a to 26f are holding means for holding an exhaust pipe and a thermocouple (a temperature measuring means) set on each of the susceptors 22a to 22f. The exhaust pipes are connected to the pipe 25b to secure the wafers 24a to 24f to the wafer mounting surfaces 23a to 23f by suction and detach the secured wafers by blowing nitrogen gas on them.

Symbol 27 is a rotary shaft to which the wafer holder 21 is secured. The wafer holder 21 rotates around the rotary shaft 27 on the moving surface put between gas dischargers 31a to 31e and heaters 28a to 28f while holding the wafers 24a to 24f.

Symbols 28a to 28f are heaters (heating instruments) respectively facing the susceptors 22a to 22f on the wafer holder 21. The heaters 28a to 28f are separated from each other so as to independently supply electric power, which heat the susceptors 22a to 22f from the opposite side of the wafer mounting surfaces 23a to 23f by means of heat radiation and heat conduction. Thereby, the temperature of the susceptors 22a to 22f rises and the wafers 24a to 24f are indirectly heated. However, Fig. 7 shows only the heaters 28c and 28f among the heaters 28a to 28f.

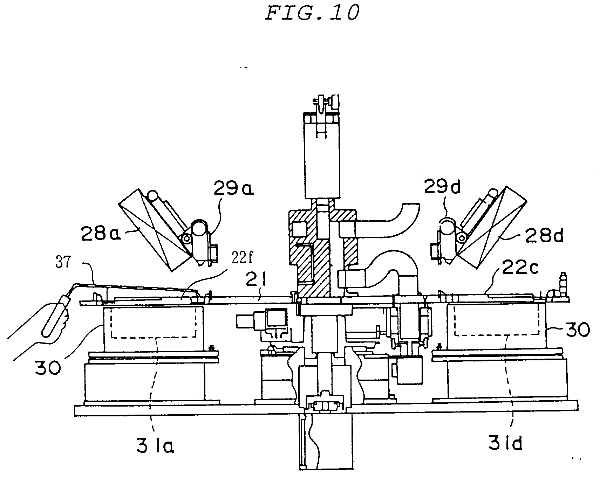

Each of the heaters 28a to 28f is secured to each of rotary shafts 29a to 29f parallel with the mounting surfaces of the susceptors 22a to 22f respectively and each of the heaters 28a to 28f turns on each of shafts 29a to 29f respectively downward or upward so that approaching the wafer holder 21, or going away from the wafer holder 21 to make room above the wafer holder 21 to set or detach the susceptors 22a to 22f. However, Fig. 10 shows only the rotary shafts 29c and 29f among the rotary shafts 29a to 29f.

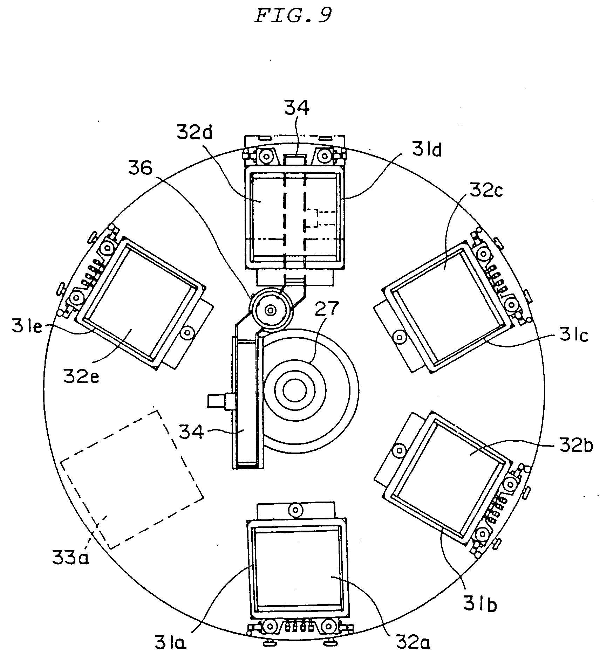

In Figs. 7 and 9, symbol 30 is a gas distributing instrument for supplying reaction gas to wafers and independent gas dischargers 31a to 31e are set to five places at intervals corresponding to the intervals of the susceptors 22a to 22f along the circumference around the rotary shaft 27. However, there is one place to which no gas discharger is set. That is, the place is a loading/unloading portion 33a. Used or nnecessary reaction gas is exhausted through an exhaust port close to the gas dischargers 31a to 31e. The gas discharge surfaces 32a to 32e of the gas dischargers 31a to 31e are turned upward to face the wafer mounting surfaces 23a to 23f of the susceptors 22a to 22f.

Symbol 34 is a cleaner for removing reaction products sticking to the gas discharge surfaces 32a to 32e. The cleaner 34 is secured to a rotary shaft 36 moving together with the wafer holder 21, which is housed in the vicinity of the rotary shaft 27 of the wafer holder 21 when it is not used and moved onto the gas discharge surfaces 32a to 32e when it is used. When cleaning the gas discharge surfaces 32a to 32e, the cleaner 34 rubs the gas discharge surfaces 32a to 32e with a brush 35 to remove dust from the surfaces and immediately draws in the removed dust so that it does not scatter.

For the CVD apparatus of the above embodiment of the present invention, the wafer holder 21 is secured to the rotary shaft 27 and rotates around the rotary shaft 27 on the moving surface put between the gas dischargers 31a to 31e and heaters 28a to 28f while holding the wafers 24a to 24f.

Therefore, the wafers 24a to 24f are moved along the circumference around the rotary shaft 27, it is possible to continuously form films and keep a high throughput.

Moreover, because the wafer holder 21 is separated from the heaters 28 to 28f, it is possible to connect electrical wiring to the secured heaters 28a to 28f. Therefore, the structure of the CVD apparatus are simplified and the maintenance is easy.

Besides, it is considered to combine the wafer holder 21 with the heaters 28a to 28f. In this case, however, the structure is complicated including electrical wiring connection to the rotating heaters 28a to 28f. Therefore, the constitution of the first embodiment of the present invention is more advantageous.

Furthermore, because the susceptors 22a to 22f and gas dischargers 31a to 31e separated from each other are used, it is possible to precisely control the production of each wafer and form different types of multilayer films.

Furthermore, because the wafer holder 21 has the detachable susceptors 22a to 22f separated from each other, it is possible to easily and efficiently perform maintenance and checkout.

Furthermore, because the apparatus has the rotary shafts 29a to 29f capable of making the heaters 28a to 28f approach or go away from the wafer holder 21 by turning the heaters downward or upward, it is possible to efficiently heat the wafers 28a to 28f by making them approach the wafer holder 21 and easily set or detach the susceptors 22a to 22f by making them go away from the holder to make room above the susceptors 22a to 22f.

For this embodiment, the gas distributor 30 is set under the wafer holder 21 and the heaters 28a to 28f are set above the wafer holder 21. However, it is also possible to set the gas distributor 30 above the wafer holder 21 and the heaters 28a to 28f under the holder.

### (B) Detailed description of constitution of susceptor and constitution of holder for an exhaust pipe and a thermocouple

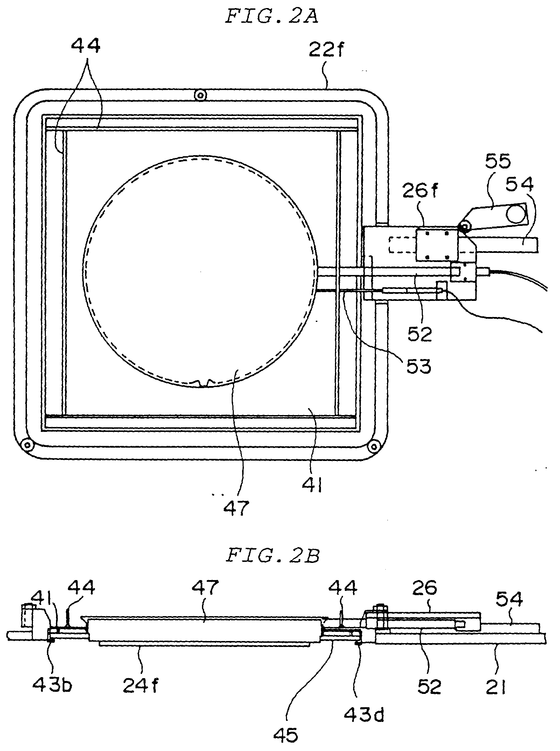

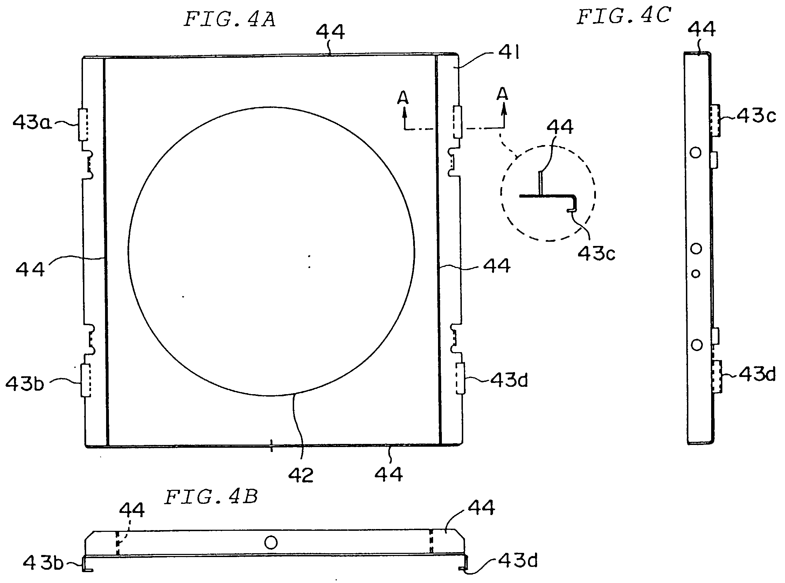

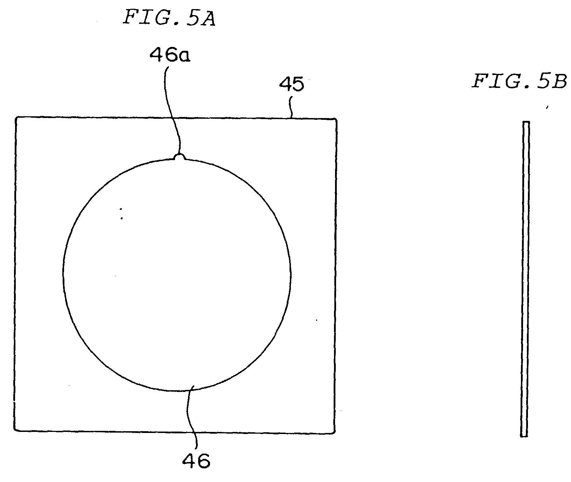

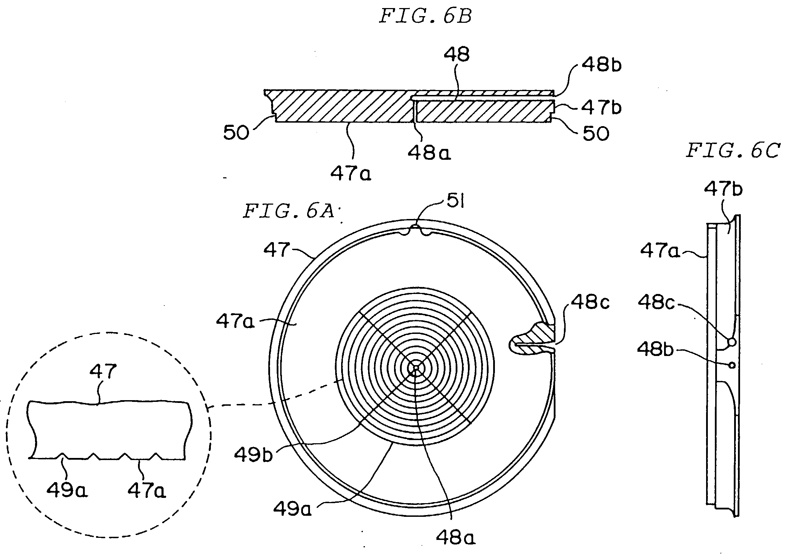

The constitution of a susceptor and that of a holder for an exhaust pipe and a thermocouple are described below in detail by referring to Figs. 2A and Figs. 2B, Figs. 3A to Figs. 3D, Figs. 4A to Figs. 4C, Figs. 5A and Figs. 5B, and Figs. 6A to Figs. 6C.

In these figures, symbol 41 is a frame made of square aluminum board with a circular opening 42 formed at the center. Moreover, hooking portions 43a to 43d are formed on the margin of the frame 41 at four points one each, to which a flat holding frame 45 is hooked. A columnar wafer mounting table 47 is put into the opening 42 of the frame 41 and the opening 46 of the holding frame 45. Moreover, a screen-shaped heat shield 44 for interrupting the heat from the heated wafer mounting table 47 is provided at the margin of the opening 42 on a face opposite to the face where the hooking portions 43a to 43d are formed.

Symbol 45 is a flat holding frame to be hooked to the hooking portions 43a to 43d of the frame 41. The opening 46 where the wafer mounting table 47 is put is formed on the holding frame 45 and moreover a recessed aligning portion 46a is provided at the margin of the opening 46 so that the wafer mounting table 47 is settled at a predetermined position. To prevent the conduction of heat from the heated wafer mounting table 47, the holding frame 45 is made of quartz having an adiabatic effect.

Symbol 47 is a wafer mounting table made of stainless steel, which has a large heat capacity so that the temperature raised due to heating does not easily lower. Suction ports 48a and 48b are formed on a wafer mounting surface 47a and its side face 47b respectively. The suction ports 48a and 48b are connected each other by a through-hole 48 in the wafer mounting table 47. A recessed portion 48c to which a thermocouple (temperature measuring means) is set is formed at the side face 47b of the wafer mounting table 47 adjacently to the suction port 48b.

Moreover, concentric grooves 49a around the suction port 48a and radial grooves 49b crossing the concentric grooves 49a and reaching the suction port 48a are formed on the wafer mounting surface 47a. When a wafer is mounted on the wafer mounting table 47 and evacuation is performed, the gas in these grooves 49a and 49b are exhausted and the wafer is drown in and secured. This function is called a vacuum chuck.

Moreover, a hooking portion 50 for hooking the holding frame 45 is formed at the side face of the wafer mounting table 47. The wafer mounting table 47 has a protruded aligning portion 51 to be fitted to the aligning portion 46a of the holding frame 45.

Symbol 26f is a holder for holding both an exhaust pipe 52 and the thermocouple 53, which is pressed against the wafer mounting table 47 by a spring. The exhaust pipe 52 and the thermocouple 53 are set to or detached from the wafer mounting table 47 by making the holder 26f approach or go away from the side face 25b of the wafer mounting table 47 on a rail 54 provided on the surface of the wafer holder 21. Moreover, a fastener 55 for stopping the movement of the holder 26f pressed by the spring is provided to keep the holder 26f away from the wafer mounting table 47.

As described above, a susceptor of the embodiment of the present invention makes it possible to connect or disconnect an exhaust system to or from the suction port 48b at the side face 47b of the wafer mounting table 47 with the exhaust pipe 52 movable on a plane. Therefore, it is possible to set the exhaust system to the wafer mounting table 47 in forming a film and detach the system from the table in the case of repair or the like. Thus, the apparatus can be more easily maintained or checked.

Moreover, the thermocouple 53 can be set to or detached from the wafer mounting table 47 because it is movable on a plane. Therefore, it is possible to set the thermocouple 53 to the wafer mounting table 47 in forming a film and detach it from the table for repair or the like. Thereby, the apparatus can be more easily maintained or checked.

Moreover, because both the exhaust pipe 52 and the thermocouple 53 are held by the holing means 26f movable on a plane, the exhaust pipe 52 and thermocouple 53 can be simultaneously set or detached by moving the holding means 26f.

### (C) Description of susceptor setting/detaching method

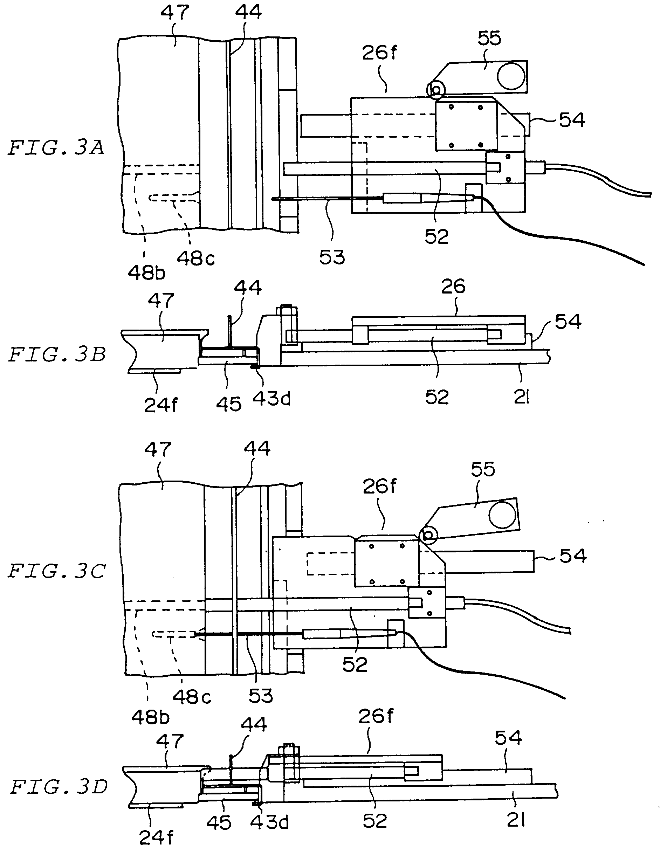

A method for setting or detaching the susceptors 22a to 22f to or from the wafer holder 21 is described below by referring to Figs. 3 (a) to 3 (d) and Fig. 10.

It is necessary to set or detach the susceptors 22a to 22f when replacing them with new ones.

To set the susceptor 22f to the wafer holder 21, it is first necessary to remove the heater 28a proximately provided on the setting surface of the susceptor 22f so that the heater does not interrupt setting of the susceptor 22f. Because the heater 28a can turn downward or upward on the rotary shaft 29a parallel with the setting surface of the susceptor 22f, the heater 28a is turned upward as shown in Fig. 10 to make room above the susceptor 22f setting surface. Thereby, following that, the susceptor 22f is set to the setting surface of susceptor 22f by hand or with a setting/detaching instrument 39. At that time, the holder 26f is kept away from the side face 47b of the wafer mounting table 47 and the exhaust pipe 52 and thermocouple 53 are disconnected from the wafer mounting table 47.

Then, as shown in Figs. 3C and Figs. 3D, the holder 26f is moved to approach the side face 47b of the wafer mounting table 47 whereby both the exhaust pipe 52 and thermocouple 53 are set to the suction port 48b and the recessed portion 48c respectively.

After the susceptor 22f is set, the next susceptor 22e is set in the same way as the above. Thus, the susceptors 22d to 22a are set one by one to complete the setting of all susceptors 22a to 22f.

It is also possible to detach the susceptors 22a to 22f by reversing the above procedure.

As described above, the susceptors 22a to 22f can be easily set or detached by turning the heaters 28a to 28f on the rotary shafts 29a to 29f.

Because the heaters 28a to 28f turn on the rotary shafts 29a to 29f, it is possible to always set each of the heaters 28a to 28f to a predetermined position above each of the susceptors 22a to 22f. Thereby, it is possible to decrease temperature fluctuation due to a defference from heat radiation and heat conduction among heaters 28a to 28f.

### (D) Description of the method for forming film using CVD apparatus of the embodiment of the present invention

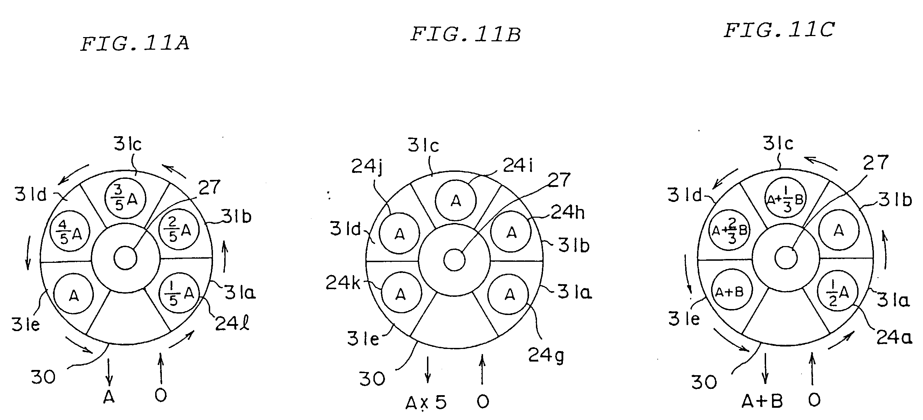

A method for forming a two-layer insulating film on a wafer by using the CVD apparatus having the gas distributor 30 and wafer holder 21 shown in Fig. 7 are described below by referring to Figs. 2 to 10 and Figs. 11C. In this case, as shown in Figs. 11C, a two-layer film made of a CVDSiO₂ film and a PSG film of which each has a predetermined thickness are formed on the wafers 24a to 24f while the wafer holder 21 makes a round of the rotary shaft 27. In Fig. 11C, symbol A represents a predetermined thickness of the CVDSiO₂ film formed on the wafers 24a to 24f and B represents a predetermined thickness of the PSG film.

First, the rotary shafts 29a to 29f are rotated to make the heaters 28a to 28f go away from the wafer holder 21 and set the susceptors 22a to 22f. Then, the rotary shafts 29a to 29f are rotated to make the heaters 28a to 28f approach the wafer holder 21. Then, the holders 26a to 26f are moved to approach the side face 47b of the wafer mounting table 47 of the susceptors 22a to 22f to set the exhaust pipe 52 to the suction port 48b and the thermocouple 53 to the recessed portion 48c respectively.

Then, the first wafer 24a is transferred underneath the susceptor 22a located at the loading/unloading portion 33a from a cassette station by a not-illustrated robot.

Then, the first wafer 24a is contacted to the wafer mounting surface 23a of the susceptor 22a, air is exhausted through the exhaust port/gas introduction port 25a, and a not-illustrated solenoid valve is opened to secure the first wafer 24a to the wafer mounting surface 23a by suction. Then, electric power is supplied to all heaters 28a to 28f to heat all susceptors 22a to 22f and keep the temperature of all wafer mounting surfaces 23a to 23f at approx. 350°C.

Then, after the temperature of the first wafer 24a reaches approx. 350°C, the rotary shaft 27 is rotated counterclockwise and the rotation is stopped when the susceptor 22a comes to a position just above the gas discharger 31a. In this case, because the moving time is as short as approx. 0.8 sec and the susceptor 22a has a large heat capacity, the temperature of the first wafer 24a hardly lowers during the moving period.

Then, a mixture gas of TEOS-O₃ is discharged from the gas discharger 31a as a reaction gas. In this case, the deposition rate of a SiO₂ film comes to approx. 2,000 Å. After approx. 1 min, an SiO₂ film with a thickness of approx. 2,000 Å which is approx. 1/2 the predetermined thickness is formed on the first wafer 24a. While the film is formed, the reaction gas is uniformly supplied onto the first wafer 24a because the susceptor 22a performs a linear reciprocative motion by a not-illustrated oscillation unit in the radial direction around the position where it is held. Thereby, the thickness of the formed SiO₂ film is uniformed and the film quality is improved.

During the above period, the second wafer 24b is mounted on the susceptor 22b located at the loading/unloading portion 33a and the temperature of the second wafer 24b is kept at approx. 350°C, similarly to the above mentioned.

Then, the rotary shaft 27 is rotated and the rotation is stopped when the susceptors 22b and 22a come to positions just above the gas dischargers 31a and 31b respectively. In this case, it is possible to immediately start forming a film because the temperature of the second wafer 24b already reaches approx. 350°C. Therefore, the TEOS-O₃ mixture gas is immediately discharged from the gas dischargers 31a and 31b as a reaction gas. When this state is kept for approx. 1 min, an SiO₂ film with a thickness of approx. 4,000 Å which is the predetermined thickness is formed on the first wafer 24a and an SiO₂ film with a thickness of approx. 2,000 Å which is approx. 1/2 the predetermined thickness is formed on the second wafer 24b.

During the above period, the third wafer 24c is mounted on the susceptor 22c located at the loading/unloading portion 33a and the temperature of the third wafer 24c is kept at approx. 350°C, similarly to the above mentioned.

Then, the rotary shaft 27 is rotated and the rotation is stopped when the susceptors 22c, 22b, and 22a come to positions just above the gas dischargers 31a, 31b, and 31c respectively. In this case, it is possible to immediately start forming a film because the temperature of the third wafer 24c already reaches approx. 350°C. Therefore, a mixture gas of TEOS-O₃ and TMPO is immediately discharged from the gas dischargers 31a, 31b, and 31c as a reaction gas. When this state is kept for approx. 1 min, a PSG film with a thickness of approx. 2,000 Å which is approx. 1/3 the predetermined thickness is formed on the first wafer 24a, an SiO₂ film with a thickness of approx. 4,000 Å which is the predetermined thickness is formed on the second wafer 24b, and moreover, an SiO₂ film with a thickness of 2,000 Å which is approx. 1/2 the predetermined thickness is formed on the third wafer 24c.

Thus, wafers are set to the susceptors 22d to 22f to send them one by one and form a two-layer insulating film made of both an SiO₂ film and PSG film on each wafer. When the first wafer 24a makes a round of the rotary shaft 27 and returns to the loading/unloading portion 33a, the SiO₂ film and the PSG film with the predetermined thickness are formed on the first wafer 24a. During the above period, the wafer temperature for forming a film is very stable.

When a robot is moved to the loading/unloading portion 33a, a solenoid valve for operating the vacuum chuck of the susceptor 22a is closed, and a not-illustrated nitrogen-introduction valve is opened to supply nitrogen gas to the vacuum chuck, the first wafer 24a is held by the robot and detached from the wafer mounting surface 23a. Then, the first wafer 24a is transferred to a cooling chamber on the cassette station by the robot. The first wafer 24a transferred to the cooling chamber is air-cooled by blowing nitrogen gas on it and housed in a wafer cassette. Thus, an SiO₂ film and a PSG film of which each has a predetermined thickness are successively formed on wafers and the wafers are accumulated in the wafer cassette.

As described above, the method for forming a SiO₂ film using the CVD apparatus of the first embodiment makes it possible to keep a high throughput because the loading/unloading time is not explicitly added to a film forming period by performing the loading/unloading while forming a film.

Moreover, by setting the susceptors 22a to 22f and the dischargers 31a to 31e separately from each other, it is possible to accurately control the production of each wafer.

Furthermore, because each of the susceptors 22a to 22f performs a linear reciprocative motion in the radial direction around the position where each of them is held, a reaction gas is uniformly supplied to wafers.

Though the heaters 28a to 28f are separated from the wafer holder 21 and moving wafers go away from the heaters 28a to 28f, the wafer temperature hardly fluctuates because the wafer mounting table 47 has a large heat capacity and completes movement in a short time. Thereby, it is possible to form a film with a uniform thickness and a high quality on wafers.

For the above method for manufacturing the semiconductor device, a two-layer insulating film is formed by using two types of reaction gases. However, as shown in Fig. 11A, it is also possible to form a single film on the wafer 241 while the wafer 241 makes a round by supplying one type of gas to the gas dischargers 31a to 31e.

Moreover, it is possible to form a single film by a method similar to the batch system by previously setting wafers 24g to 24k to all the susceptors 22a to 22f and thereafter forming a film on the wafers 24g to 24k at the same time by using one type of reaction gas.

## Claims

1. An apparatus for forming a film onto wafers (24a - 24f) comprising:
a rotary shaft (27);
a heating device arranged around said rotary shaft (27);
a plurality of gas dischargers (31a - 31e) discharging a reaction gas and facing said heating device (28a - 28f);
a wafer holder (21) having a plurality of detachable susceptors (22a - 22f) separated from each other with the wafer holder being (21) rotatable about said rotary shaft (27) along a single plane between said heating device (28a - 28f) and said gas dischargers (31a - 31e);
characterized in that
the heating device is formed by a plurality of heaters (28a - 28f) arranged in a circle around said rotary shaft (27); the plurality of gas dischargers (31a - 31e) is facing said heaters (28a - 28f), each of said gas dischargers (31a - 31e) being paired and aligned with one of said heaters (28a - 28f); and the plurality of susceptors (22a - 22f) is arranged in a circle around said rotary shaft (27), each of said susceptors (22a - 22f) comprising a wafer mounting table (47) providing on one side thereof a wafer mounting surface (47a) for mounting one of said wafers (24a - 24f), facing said gas dischargers (31a - 31e) so that the surface of each of said susceptors (22a - 22f) opposite to the wafer mounting surface (47) faces one of said heaters (28a -28f).

2. The apparatus for forming a film according to claim 1, further comprising:
a recess (48c) formed in a side surface (47b) of said wafer mounting table (47); and temperature measuring means (53) inserted into said recess (48c).

3. The apparatus for forming a film according to claim 1 or 2 further comprising:
a suction port (48b) formed at a side surface (47b) of said wafer mounting table (47);
at least one port (48a) at said wafer mounting surface (47a) of said wafer mounting table (47);
an internal duct (48) providing fluid communication between said suction port (48b) and said port (48a) at said wafer mounting surface (47a) for applying a vacuum and gas pressure; and an exhaust pipe (52) detachably connected to said suction port (48b).

4. The apparatus for forming a film according to one of claims 1 to 3, further comprising:
holding means (26a - 26f) associated with each of said susceptors (22a - 22f) for securing one exhaust pipe (52) and one temperature measuring means (53) to one wafer mounting table (47).

5. The apparatus for forming a film according to claim 4, wherein said holding means (26a - 26f) is mounted on a rail (54) for a reciprocating movement relative to said wafer holder (21) surface between a first position, wherein said exhaust pipe (52) is connected to said suction port (48b) in said side surface (47b) and said temperature measuring means (53) is inserted into said recess (48c), and a second position wherein said exhaust pipe (52) is disconnected from said suction port (48b) in said side surface (47b) and said temperature measuring means (53) is withdrawn from said recess (48c).

6. The apparatus for forming a film according to one of claims 1 to 5, wherein each of said susceptors (22a - 22f) further comprises a frame (41) mounting said wafer mounting table (47) therein, wherein at least the portion in said frame (41) which is in contact with said mounting table (47) is fabricated of a heat-insulating material.

7. The apparatus for forming a film according to one of claims 1 to 6, wherein each of said heaters (28a - 28f) is pivotably mounted for a pivot motion about an axis (29a-29f) parallel to said single plane.

## Patentansprüche

1. Vorrichtung zur Bildung eines Films auf Wafers (24a-24f) mit:
einer rotierenden Welle (27);
einer um die rotierende Welle (27) herum angeordneten Heizeinrichtung;
mehreren Gasabgabeeinrichtungen (31a-31e), welche ein Reaktionsgas abgeben und der Heizeinrichtung (28a-28f) zugewandt sind;
einem Waferhalter (21) mit mehreren lösbaren, voneinander getrennten Aufnehmern (22a-22f), wobei der Waferhalter (21) um die rotierende Welle (27) in einer einzigen Ebene zwischen der Heizeinrichtung (28a-28f) und den Gasabgabeeinrichtungen (31a-31e) drehbar ist;
dadurch gekennzeichnet, daß
die Heizeinrichtung durch eine Vielzahl von Heizelementen (28a-28f) gebildet wird, die in einem Kreis um die rotierende Welle (27) herum angeordnet sind; die Gasabgabeeinrichtungen (31a-31e) den Heizelementen (28a-28f) gegenüberliegen, wobei jede der Gasabgabeeinrichtungen (31a-31e) mit einem der Heizelemente (28a-28f) paarweise ausgerichtet ist; und die Aufnehmer (22a-22f) sind in einem Kreis um die rotierende Welle (27) herum angeordnet, wobei jeder Aufnehmer (22a-22f) eine Waferbefestigungsplatte (47) aufweist, die auf einer Seite eine Waferbefestigungsoberfläche (47a) zur Befestigung einer der Wafer (24a-24f) gegenüber den Gasabgabeeinrichtungen (31a-31e) ausbildet, so daß die Oberfläche jedes der gegenüber der Waferbefestigungsoberfläche (47a) gelegenen Aufnehmer (22a-22f) einem der Heizelemente (28a-28f) zugewandt ist.

2. Vorrichtung zur Bildung eines Films nach Patentanspruch 1, gekennzeichnet durch eine in einer Seitenoberfläche (47b) der Waferbefestigungsplatte (47) gebildeten Aussparung (48c); und durch Temperaturmeßmittel (53), die in die Aussparung (48c) eingefügt sind.

3. Vorrichtung zur Bildung eines Films nach Patentanspruch 1 oder 2, gekennzeichnet durch
eine an einer Seitenoberfläche der Waferbefestigungsplatte (47) ausgebildete Saugöffnung (48b) ;
mindestens eine Öffnung (48a) an der Waferbefestigungsoberfläche (47a) der Waferbefestigungsplatte (47);
eine innere Leitung (48), die eine Fluid-Verbindung zwischen der Saugöffnung (48b) und der Öffnung (48a) an der Waferbefestigungsoberfläche (47a) herstellt, um einen Unterdruck und einen Gasdruck anzulegen; und eine Auslaßleitung (52), welche abnehmbar mit der Saugöffnung (48b) verbunden ist.

4. Vorrichtung zur Bildung eines Films nach einem der Patentansprüche 1 bis 3, gekennzeichnet durch
jedem der Aufnehmer (22a-22f) zugeordnete Halteeinrichtungen (26a-26f) zur Befestigung eines Auslaßrohrs (52) und eines Temperaturmeßmittels (53) an der Waferbefestigungsplatte (47).

5. Vorrichtung zur Bildung eines Films nach Patentanspruch 4, dadurch gekennzeichnet, daß die Halteeinrichtungen (26a-26f) auf einer Schiene (54) gelagert sind zwecks Hin- und Herbewegung relativ zur Oberfläche des Waferhalters (21) zwischen einer ersten Stellung, in der das Auslaßrohr (52) mit der Saugöffnung (48b) in der Seitenoberfläche (47b) verbunden und das Temperaturmeßmittel (53) in die Aussparung (48c) eingefügt ist, und einer zweiten Stellung, in der das Auslaßrohr (52) von der Saugöffnung (48b) in der Seitenoberfläche (47b) getrennt und das Temperaturmeßmittel (53) aus der Aussparung (48c) zurückgezogen ist.

6. Vorrichtung zur Bildung eines Films nach einem der Patentansprüche 1 bis 5, dadurch gekennzeichnet, daß jeder der Aufnehmer (22a-22f) einen Rahmen (41) zur Halterung der Waferbefestigungsplatte (47) darin aufweist, wobei zumindest derjenige Teil des Rahmens (41) aus wärmeisolierendem Material hergestellt ist, der in Kontakt mit der Befestigungsplatte (47) steht.

7. Vorrichtung zur Bildung eines Films nach einem der Patentansprüche 1 bis 6, dadurch gekennzeichnet, daß jedes der Heizelemente (28a-28f) schwenkbar gelagert ist für eine Schwenkbewegung um eine Achse (29a-29f) parallel zu der einzigen Ebene.

## Revendications

1. Appareil pour former un film sur des tranches (24a à 24f) comportant :
un arbre rotatif (27) ;
un dispositif de chauffage agencé autour dudit arbre rotatif (27) ;
une pluralité de déchargeurs de gaz (31a à 31e) déchargeant un gaz de réaction et situés en vis-à-vis dudit dispositif de chauffage (28a à 28f) ;
un support de tranches (21) comportant une pluralité de suscepteurs amovibles (22a à 22f) séparés les uns des autres, le support de tranches (21) pouvant tourner autour dudit arbre rotatif (27) le long d'un plan unique entre ledit dispositif de chauffage (28a à 28f) et lesdits déchargeurs de gaz (31a à 31e) ;
caractérisé en ce que
le dispositif de chauffage est formé d'une pluralité d'éléments de chauffage (28a à 28f) agencés en formant un cercle autour dudit arbre rotatif (27) ; la pluralité de déchargeurs de gaz (31a à 31e) est située en vis-à-vis desdits éléments de chauffage (28a à 28f) ; chacun desdits déchargeurs de gaz (31a à 31e) étant apparié et aligné avec l'un desdits éléments de chauffage (28a à 28f) ; et la pluralité de suscepteurs (22a à 22f) est agencée en formant un cercle autour dudit arbre rotatif (27), chacun desdits suscepteurs (22a à 22f) comportant une table de montage de tranche (47) fournissant, au niveau d'un premier côté de celle-ci, une surface de montage de tranche (47a) destinée au montage de l'une desdites tranches (24a à 24f), située en vis-à-vis desdits déchargeurs de gaz (31a à 31e) de sorte que la surface de chacun desdits suscepteurs (22a à 22f), opposée à la surface de montage de tranche (47), soit située en vis-à-vis de l'un desdits éléments de chauffage (28a à 28f).

2. Appareil pour former un film selon la revendication 1, comportant en outre :
un évidement (48c) formé dans une surface latérale (47b) de ladite table de montage de tranche (47), et de moyens de mesure de température (53) insérés dans ledit évidement (48c).

3. Appareil pour former un film selon la revendication 1 ou 2, comportant en outre :
un orifice d'aspiration (48b) formé au niveau d'une surface latérale (47b) de ladite table de montage de tranche (47) ;
au moins un orifice (48a) situé au niveau de ladite surface de montage de tranche (47a) de ladite table de montage de tranche (47) ;
un conduit intérieur (48) assurant la communication d'un fluide entre ledit orifice d'aspiration (48b) et ledit orifice (48a) situé au niveau de ladite surface de montage de tranche (47a) de manière à appliquer un vide et une pression de gaz, et un tuyau d'évacuation (52) relié de manière amovible audit orifice d'aspiration (48b).

4. Appareil pour former un film selon l'une quelconque des revendications 1 à 3, comportant en outre :
des moyens de maintien (26a à 26f), associés à chacun desdits suscepteurs (22a à 22f), pour fixer un tuyau d'évacuation (52) et des moyens de mesure de température (53) à une table de montage de tranche (47).

5. Appareil pour former un film selon la revendication 4, dans lequel lesdits moyens de maintien (26a à 26f) sont montés sur un rail (54) de manière à se déplacer alternativement par rapport à ladite surface du support de tranches (21) entre une première position, dans laquelle ledit tuyau d'évacuation (52) est relié audit orifice d'aspiration (48b) situé dans ladite surface latérale (47b) et lesdits moyens de mesure de température (53) sont insérés à l'intérieur dudit évidement (48c), et une seconde position dans laquelle ledit tuyau d'évacuation (52) est déconnecté dudit orifice d'aspiration (48b) situé dans ladite surface latérale (47b) et lesdits moyens de mesure de température (53) sont retirés dudit évidement (48c).

6. Appareil pour former un film selon l'une quelconque des revendications 1 à 5, dans lequel chacun desdits suscepteurs (22a à 22f) comporte en outre un châssis (41) sur lequel est monté ladite table de montage de tranche (47), dans lequel au moins la partie dudit châssis (41) qui est en contact avec ladite table de montage (47) est réalisée en un matériau thermiquement isolant.

7. Appareil pour former un film selon l'une quelconque des revendications 1 à 6, dans lequel chacun desdits éléments de chauffage (28a à 28f) est monté de manière pivotante pour effectuer un mouvement de pivotement autour d'un axe (29a à 29f) parallèle audit plan unique.
